Europäisches Patentamt

European Patent Office

Office européen des brevets

(11) Veröffentlichungsnummer: **0 483 494 A2**

## EUROPÄISCHE PATENTANMELDUNG

(21) Anmeldenummer: **91115303.9**

(51) Int. Cl.⁵: **G01R 27/14**

(22) Anmeldetag: **10.09.91**

(30) Priorität: **31.10.90 DE 4034699 U**

(43) Veröffentlichungstag der Anmeldung:
**06.05.92 Patentblatt 92/19**

(84) Benannte Vertragsstaaten:
**AT DE FR GB NL**

(71) Anmelder: **FRAUNHOFER-GESELLSCHAFT ZUR FÖRDERUNG DER ANGEWANDTEN FORSCHUNG E.V.**
**Leonrodstrasse 54**
**W-8000 München 19(DE)**

(72) Erfinder: **Wallrapp, Ludwig, Dipl.-Ing.**
**Hollerweg 5**
**W-8520 Erlangen(DE)**
Erfinder: **Seitzer, Dieter**
**Humboldtstrasse 14**
**W-8520 Erlangen(DE)**

(74) Vertreter: **Schoppe, Fritz, Dipl.-Ing.**
**Seitnerstrasse 42**
**W-8023 Pullach bei München(DE)**

(54) **Widerstandsmessschaltung.**

(57) Ein Widerstandsmeßschaltung zum Erzeugen eines zu einem Widerstandswert eines zu messenden Widerstandes (RM) umgekehrt proportionalen Spannungsausgangssignales (UA) umfaßt eine Bezugsspannungsquelle (UR) einen ersten Operationsverstärker (OP1), dessen nicht-invertierender Eingang mit der Bezugsspannungsquelle (UR) und dessen invertierender Eingang mit einem ersten Anschluß des zu messenden Widerstandes (RM) verbunden ist, dessen zweiter Anschluß gegen ein Bezugspotential geschaltet ist, einer Reihenschaltung eines Bezugswiderstandes (RR) und eines weiteren Widerstandes (RL), die zwischen einem Ausgang des ersten Operationsverstärkers (OP1) und dem ersten Anschluß des zu messenden Widerstandes (RM) geschaltet ist, und eine Spannungssubtraktionsschaltung, die eingangsseitig mit dem Ausgang des ersten Operationsverstärkers (OP1) und mit dem gemeinsamen Knoten (K1) des Bezugswiderstandes (RR) und des weiteren Widerstandes (RL) verbunden ist und ausgangsseitig ein auf das Bezugspotential bezogenes Spannungssignal erzeugt.

FIG.1

EP 0 483 494 A2

Die vorliegende Erfindung betrifft eine Widerstandsmeßschaltung zum Erzeugen eines zu einem Widerstandswert eines zu messenden Widerstandes umgekehrt proportionalen Spannungsausgangssignales nach dem Oberbegriff des Patentanspruchs 1.

Derartige Widerstandsmeßschaltungen sind seit geraumer Zeit bekannt. Bei den meisten üblichen Widerstandsmeßschaltungen liegt der zu messende Widerstand derart innerhalb der Schaltungsanordnung, daß keiner seiner beiden Anschlüsse mit Masse oder mit einem Bezugspotential verbunden ist. Bei solchen Widerstandsmeßschaltungen führen hochfrequente Störfelder, wie sie in der Meßumgebung bei den meisten Anwendungsfällen einer Widerstandsmeßschaltung vorliegen, zu einer Verfälschung der Widerstandsmessung bzw. Widerstands-Spannungs-Wandlung. Häufig liegt der zu messende Widerstand an einem Ort, der vergleichsweise weit von der eigentlichen Wandlerschaltung beabstandet ist. Die Widerstände der für den Anschluß des Meßwiderstandes verwendeten Zuleitungen gehen bei den meisten Widerstandsmeßschaltungen als Fehlergröße in das Meßergebnis ein. Es gibt zwar bereits Widerstandsmeßschaltungen, bei denen der Zuleitungswiderstand durch geeignete Schaltungsmaßnahmen kompensiert wird. Bei derartigen bekannten Schaltungen ist jedoch der Meßwiderstand nicht gegen Masse oder ein geeignetes Bezugspotential geschaltet, so daß wiederum die oben erwähnten Probleme der hochfrequenten Einstreuung von Störfeldern auftreten.

Aus der DE-OS 21 22 561 ist eine gattungsgemäße Widerstandsmeßschaltung zum Erzeugen eines zu einem Widerstandswert eines zu messenden Widerstandes umgekehrt proportionalen Spannungsausgangssignales, mit einer Bezugsspannungsquelle, die mit ihrem einen Pol gegen ein Bezugspotential geschaltet ist, und mit zwei Operationsverstärkern bekannt. Auch bei dieser Widerstandsmeßschaltung liegt der zu messende Widerstand derart innerhalb der Schaltungsanordnung, daß keiner seiner beiden Anschlüsse mit Masse oder mit einem Bezugspotential verbunden ist. Bei dieser Widerstandsmeßschaltung führen hochfrequente Störfelder, wie sie in der Meßumgebung bei den meisten Anwendungsfällen vorliegen, zu einer Verfälschung der Widerstandsmessung bzw. Widerstands-Spannungs-Wandlung.

Aus der DE-OS 25 03 515 ist bereits eine Widerstandsmeßschaltung bekannt, die als Dreileitermeßschaltung ausgeführt ist. Der Meßwiderstand ist mit einem Pol an einem ersten und zweiten Leiter angeschlossen und ist mit seinem anderen Pol an einen dritten Leiter angeschlossen, der auf Massepotential liegt. Der zweite Leiter ist mit dem nicht-invertierenden Eingang eines Operationsverstärkers verbunden. Der erste Eingang ist über einen Widerstand mit dem invertierenden Eingang des Operationsverstärkers verbunden, der über einen weiteren Widerstand mit dessen Ausgang verbunden ist. Eine Stromquelle führt einen eingeprägten Strom zu dem Verbindungspunkt des ersten Leiters mit dem ersten Widerstand zu.

Aus der DE-AS 12 81 570 ist eine Widerstandsmeßschaltung bekannt, die einen Differenzverstärker auffaßt, an dessen einen Eingang der Meßwiderstand in einem Gegenkopplungspfad angeschlossen ist, während der andere Eingang mit einer Eingangsspannungsquelle verbunden ist, wobei ferner zwischen dem Ausgang und dem einen Eingang des Differenzverstärkers ein den Verstärkungsfaktor festlegender Rückkopplungswiderstand geschaltet ist.

Ausgehend von diesem Stand der Technik liegt der vorliegenden Erfindung die Aufgabe zugrunde, eine Widerstandsmeßschaltung der eingangs genannten Art so weiterzubilden, daß die Meßgenauigkeit weiter verbessert wird.

Diese Aufgabe wird bei einer Widerstandsmeßschaltung nach dem Oberbegriff des Patentanspruchs 1 durch die im kennzeichnenden Teil des Patentanspruchs 1 angegebenen Merkmale gelöst.

Bevorzugte Weiterbildungen der erfindungsgemäßen Widerstandsmeßschaltung sind in den Unteransprüchen angegeben.

Nachfolgend werden unter Bezugnahme auf die beiliegenden Zeichnungen bevorzugte Ausführungsbeispiele der erfindungsgemäßen Widerstandsmeßschaltung näher erläutert.

Es zeigen:

Fig. 1    eine Ausführungsform des erfindungsgemäßen Widerstandsmeßschaltung für einen zu messenden Widerstand; und

Fig. 2    eine abgewandelte Ausführungsform des erfindungsgemäßen Widerstandsmeßschaltung für eine Mehrzahl von zu messenden Widerständen.

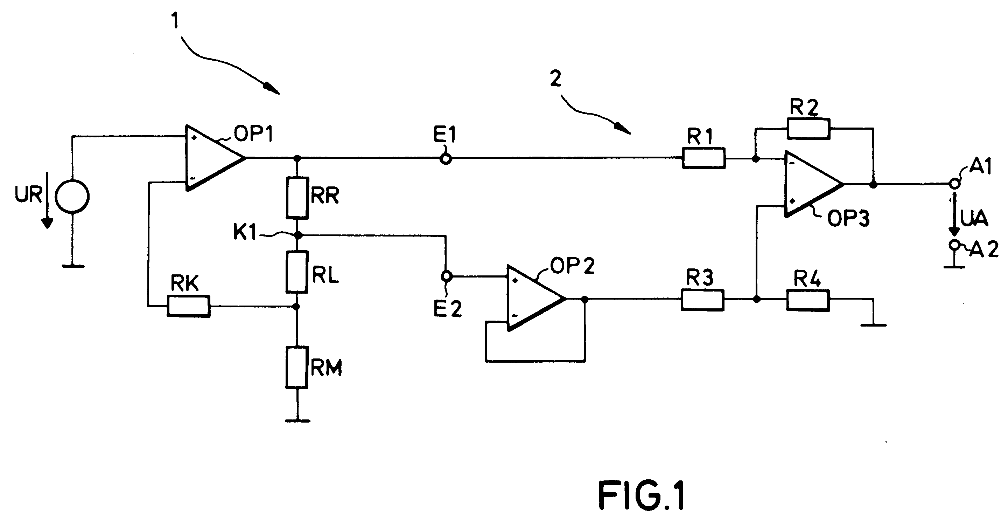

Wie in Fig. 1 gezeigt ist, umfaßt die erfindungsgemäße Widerstandsmeßschaltung, die in ihrer Gesamtheit mit dem Bezugszeichen 1 bezeichnet ist, eine Bezugsspannungsquelle UR, die mit ihrem ersten Pol gegen ein Bezugspotential geschaltet ist und einen ersten Operationsverstärker OP1. Der erste Operationsverstärker ist mit seinem nicht-invertierenden Eingang mit dem anderen Pol der Bezugsspannungsquelle UR verbunden. Der invertierende Eingang des ersten Operationsverstärkers OP1 steht über ein Zuleitungskabel, das hier durch einen Widerstand RK angedeutet ist, mit einem ersten Anschluß eines bezüglich seines Widerstandswertes zu messenden Widerstandes RM in Verbindung, dessen zweiter Anschluß gegen Masse geschaltet ist. Der Ausgang des ersten Operationsverstärkers OP1 ist über einen Bezugswiderstand RR gegen einen ersten Knoten K1 geschaltet, der über eine zweite Zuleitung, die durch einen Leitungswiderstand RL dargestellt ist, gleichfalls mit dem ersten Anschluß des bezüglich seines Widerstandswertes zu messenden Widerstandes RM verbunden ist.

Es sei angemerkt, daß in Abhängigkeit von den Anwendungsgebieten der Schaltung der Widerstand RK auch vernachlässigbar klein sein kann. Für Fachleute ist es offensichtlich, daß die Höhe dieses Widerstandes keinen Einfluß auf die Funktion der Schaltung hat, soweit man von annähernd idealen Eigenschaften des ersten Operationsverstärkers OP1 ausgeht. Der Ausgang des ersten Operationsverstärkers OP1 ist mit einem ersten Eingangsanschluß E1 einer Spannungssubtraktionsschaltung 2 verbunden, deren zweiter Eingang E2 mit dem ersten Knoten K1 verbunden ist.

Die Spannungssubtraktionsschaltung erzeugt ausgangsseitig an Ausgangsanschlüssen A1, A2 eine auf Masse bezogene Ausgangsspannung UA, die der Differenzspannung an ihren Eingangsanschlüssen E1, E2 entspricht, wobei diese Ausgangsspannung UA auf Masse bezogen ist.

Bei dem gezeigten, bevorzugten Ausführungsbeispiel umfaßt die Spannungssubtraktionsschaltung einen zweiten und einen dritten Operationsverstärker OP2, OP3 und eine nachfolgend erläuterte Widerstandsbeschaltung.

Der nicht-invertierende Eingang des zweiten Operationsverstärkers OP2, der als Impedanzwandlerschaltung arbeitet, ist mit dem zweiten Eingangsanschluß E2 verbunden, während der invertierende Eingang des zweiten Operationsverstärkers OP2 mit seinem Ausgang verbunden ist.

Der invertierende Eingang des dritten Operationsverstärkers steht mit dem ersten Eingangsanschluß E1 der Spannungssubtraktionsschaltung 2 über einen ersten Widerstand R1 in Verbindung und ist mit seinem Ausgang A1 über einen zweiten Widerstand R2 verbunden. Der nicht-invertierende Eingang des dritten Operationsverstärkers OP3 steht mit dem Ausgang des zweiten Operationsverstärkers OP2 über einen dritten Widerstand R3 und mit Masse über einen vierten Widerstand R4 in Verbindung.

Die Widerstandswerte des ersten, zweiten, dritten und vierten Widerstandes R1, R2, R3 und R4 sind gleich.

Ausgehend vom ersten Knoten K1 gesehen, hat die nachfolgende Spannungssubtraktionsschaltung 2 aufgrund der Impedanzwandlerfunktion des zweiten Operationsverstärkers OP2 einen sehr hohen Eingangswiderstand, so daß sichergestellt ist, daß der durch den Bezugswiderstand RR fließende Strom mit dem durch den Meßwiderstand RM fließenden Strom identisch übereinstimmt. Für Fachleute ist es offensichtlich, daß der durch den Meßwiderstand RM fließende Strom dem Quotienten der Bezugsspannung UR zu dem Widerstandswert des Meßwiderstandes RM entspricht.

Unter der obigen Annahme, daß die Widerstandswerte des ersten, zweiten, dritten und vierten Widerstandes einander entsprechen, stimmt die Ausgangsspannung UA mit der Differenz der Potentiale an ihren Eingangsanschlüssen E1, E2 überein. Hieraus folgt, daß die Ausgangsspannung der negativen Bezugsspannung multipliziert mit dem Quotienten des Widerstandswertes des Bezugswiderstandes RR zu demjenigen des zu messenden Widerstandes RM gleicht. Man erkennt, daß bei der erfindungsgemäßen Schaltung der Widerstandswert der Widerstände RK und RL nicht in die Ausgangsspannung eingeht, so daß es auf den Zuleitungswiderstand nicht ankommt.

Gleichfalls ist es offenkundig, daß der zu messende Widerstand gegen Masse geschaltet ist, so daß eine hochfrequenzmäßige Beeinflussung gut abschirmbar ist.

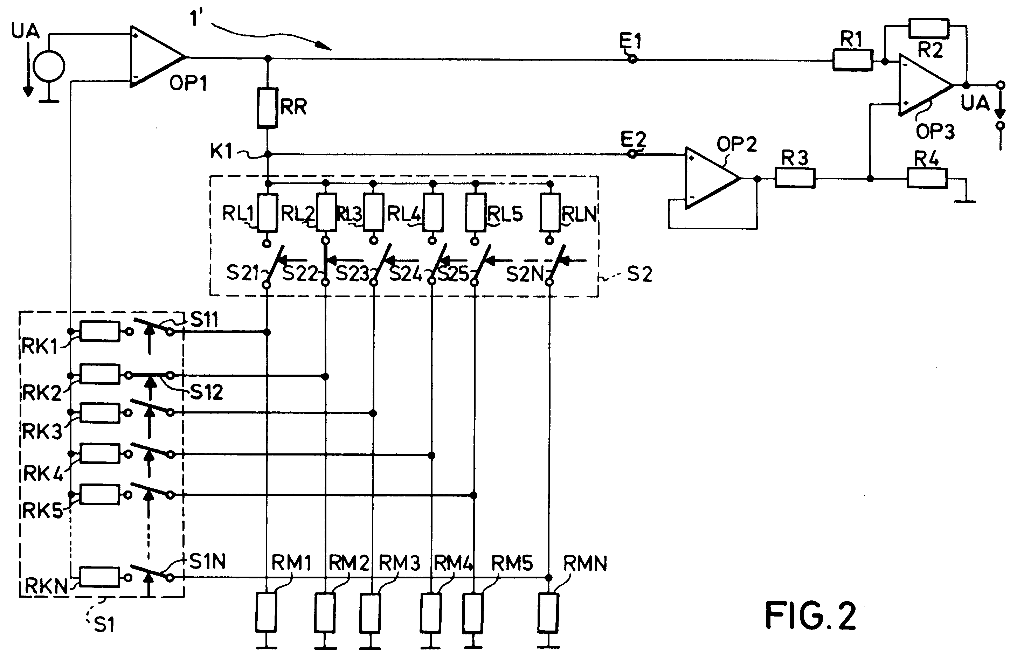

Nachfolgend wird unter Bezugnahme auf Fig. 2 eine zweite Ausführungsform des erfindungsgemäßen Widerstands-Spannungs-Wandlers näher erläutert. Mit der Ausführungsform von Fig. 1 übereinstimmende Schaltungselemente sind in beiden Figuren mit den gleichen Bezugszeichen bezeichnet, so daß eine erneute Beschreibung dieser Schaltungselemente und Schaltungsstrukturen entfallen kann. Die Ausführungsform nach Fig. 2, die in ihrer Gesamtheit mit dem Bezugszeichen 1' bezeichnet ist, umfaßt eine Mehrzahl N von zu messenden Widerständen RM1, RM2, RM3, ..., RMN die mittels einer ersten und zweiten Schalteranordnung S1, S2 alternativ sowohl an den ersten Knoten K1 als auch an den invertierenden Eingang des ersten Operationsverstärkers OP1 schaltbar sind.

Die erste Schalteranordnung S1 umfaßt eine der Mehrzahl N von zu messenden Widerständen RM1 bis RMN entsprechende Mehrzahl N von ersten Schaltern S11 bis S1N. Die ersten Schalter S11 bis S1N sind mit einem Kontakt mit dem invertierenden Eingang des ersten Operationsverstärkers OP1 und mit dem anderen Kontakt mit jeweils dem ersten Anschluß je eines der zu messenden Widerstände RM1 bis RMN verbunden. Die Schalterwiderstände der einzelnen Schalter, die auch die Zuleitungswiderstände beinhalten, sind durch die Ersatzwiderstände RK1, RK2, ..., RKN dargestellt.

Die zweite Schalteranordnung umfaßt gleichfalls eine der Mehrzahl N von zu messenden Widerständen RM1 bis RMN entsprechende Mehrzahl N von zweiten Schaltern S21 bis S2N. Die zweiten Schalter S21 bis S2N sind mit einem Kontakt mit jeweils dem ersten Anschluß eines jeden der zu messenden Widerstände RM1 bis RMN und mit dem anderen Kontakt mit dem Bezugswiderstand RR verbunden. Die den Schaltern zugeordneten Ersatzwiderstände RL1, RL2, ..., RLN bezeichnen den Durchgangswiderstand je eines geschlossenen Schalters und den Widerstand der anschließenden Zuleitung.

Durch Schließen von je einem Schalter S1I, S2I der ersten und zweiten Schalteranordnung S1, S2 kann ein zugeordneter, zu messender Widerstand RMI bezüglich seines Widerstandswertes vermessen werden. Weder Zuleitungswiderstände noch Schalterwiderstände gehen in das Meßergebnis ein.

**Patentansprüche**

1. Widerstandsmeßschaltung

   zum Erzeugen eines zu einem Widerstandswert eines zu messenden Widerstandes (RM) umgekehrt proportionalen Spannungsausgangssignales (UA), mit einer Bezugsspannungsquelle (UR), die mit ihrem einen Pol gegen ein Bezugspotential geschaltet ist, und mit wenigstens einem Operationsverstärker (OP1, OP2),

   dadurch gekennzeichnet,
   - daß der erste Operationsverstärker (OP1) mit seinem nicht-invertierenden Eingang mit dem anderen Pol der Bezugsspannungsquelle (UR) und seinem invertierenden Eingang mit einem ersten Anschluß des zu messenden Widerstandes (RM) verbunden ist, dessen zweiter Anschluß gegen das Bezugspotential geschaltet ist,
   - daß eine Reihenschaltung eines Bezugswiderstandes (RR) und eines weiteren Widerstandes (RL) zwischen einem Ausgang des ersten Operationsverstärkers (OP1) und dem ersten Anschluß des zu messenden Widerstandes (RM) geschaltet ist, und
   - daß eine Subtraktionsschaltung (OP2, OP3, R1, R2, R3, R4) vorgesehen ist, die eingangsseitig an ihrem ersten Eingangsanschluß (E1) mit dem Ausgang des ersten Operationsverstärkers (OP1) und an ihrem zweiten Eingangsanschluß (E2) mit dem gemeinsamen Knoten (K1) des Bezugswiderstandes (RR) und des weiteren Widerstandes (RL) verbunden ist und die ausgangsseitig ein auf das Bezugspotential bezogenes Spannungsausgangssignal (UA) erzeugt.

2. Widerstandsmeßschaltung nach Anspruch 1, dadurch gekennzeichnet,

   daß der weitere Widerstand (RL) durch eine erste Zuleitung zwischen dem Widerstandsmeßschaltung (1) und dem ersten Anschluß des zu messenden Widerstandes (RM) gebildet ist.

3. Widerstandsmeßschaltung nach Anspruch 1 oder 2, gekennzeichnet durch

   einen zusätzlichen Widerstand (RK), der zwischen dem invertierenden Eingang des ersten Operationsverstärkers (OP1) und dem ersten Anschluß des zu messenden Widerstandes (RM) geschaltet ist.

4. Widerstandsmeßschaltung nach Anspruch 3, dadurch gekennzeichnet,

   daß der zusätzliche Widerstand (RK) durch eine zweite Zuleitung zwischen dem Widerstandsmeßschaltung und dem ersten Anschluß des zu messenden Widerstandes (RM) gebildet ist.

5. Widerstandsmeßschaltung nach einem der Ansprüche 1 bis 4, dadurch gekennzeichnet,

   daß die Spannungssubtraktionsschaltung (OP2, OP3, R1, R2, R3, R4) einen an ihren zweiten Eingangsanschluß geschalteten Impedanzwandler (OP2) aufweist.

6. Widerstandsmeßschaltung nach Anspruch 5, dadurch gekennzeichnet,

   daß der Impedanzwandler durch einen zweiten Operationsverstärker (OP2) gebildet ist, dessen nicht-invertierender Eingang mit dem zweiten Eingangsanschluß (E2) der Spannungssubtraktionsschaltung (OP2, OP3, R1, R2, R3, R4) verbunden ist und dessen invertierender Eingang mit dessen Ausgang (A1) verbunden ist.

7. Widerstandsmeßschaltung nach Anspruch 5 oder 6, dadurch gekennzeichnet,

   daß die Spannungssubtraktionsschaltung (OP2, OP3, R1, R2, R3, R4) einen dritten Operationsverstärker (OP3) aufweist, dessen invertierender Eingang über einen ersten Widerstand (R1) mit dem ersten Eingangsanschluß (E1) der Spannungssubtraktionsschaltung und über einen zweiten Widerstand (R2) mit seinem Ausgang (A1) verbunden ist, und dessen nicht-invertierender Eingang über einen dritten Widerstand (R3) mit dem Ausgang der Impedanzwandlerschaltung (OP2) und über einen vierten Widerstand (R4) mit dem Bezugspotential verbunden ist.

8. Widerstandsmeßschaltung nach Anspruch 7, dadurch gekennzeichnet,

daß die Widerstandswerte des ersten, zweiten, dritten und vierten Widerstandes miteinander übereinstimmen.

9. Widerstandsmeßschaltung nach einem der Ansprüche 1 bis 8, dadurch gekennzeichnet,

daß das Bezugspotential Masse ist.

10. Widerstandsmeßschaltung mit einer Mehrzahl (N) von zu messenden Widerständen (RM1 bis RMN) nach einem der Ansprüche 1 bis 9, gekennzeichnet durch
- eine dieser Mehrzahl entsprechende Mehrzahl (N) von ersten Schaltern (S11 bis S1N), die mit einem Kontakt mit dem invertierenden Eingang des ersten Operationsverstärkers (OP1) und mit dem anderen Kontakt mit jeweils dem ersten Anschluß je eines der zu messenden Widerstände (RM1 bis RMN) verbunden sind, und
- eine der Mehrzahl entsprechende Mehrzahl (N) von zweiten Schaltern (S21 bis S2N), die mit einem Kontakt mit jeweils dem ersten Anschluß je eines der zu messenden Widerstände (RM1 bis RMN) und mit dem anderen Kontakt mit dem Bezugswiderstand (RR) verbunden sind.

FIG.1

EP 0 483 494 A2

FIG.2

EP 0 483 494 A2